# FASCICULE DE BREVET EUROPEEN

(11) **EP 3 015 888 B1**
(45) Date de publication et mention de la délivrance du brevet: **27.09.2017**
(21) Numéro de dépôt: 15190997.5
(22) Date de dépôt: 22.10.2015
(51) Int. Cl.: G02B 6/30, G02B 6/12, G02B 6/124

(54) **SUBSTRAT PRÉ-STRUCTURÉ POUR LA RÉALISATION DE COMPOSANTS PHOTONIQUES, CIRCUIT PHOTONIQUE ET PROCÉDÉ DE FABRICATION ASSOCIÉS**
VORSTRUKTURIERTES SUBSTRAT FÜR DIE HERSTELLUNG VON PHOTONISCHEN KOMPONENTEN, ENTSPRECHENDER PHOTONENSCHALTKREIS UND ENTSPRECHENDES HERSTELLUNGSVERFAHREN
PRE-STRUCTURED SUBSTRATE FOR PRODUCING PHOTONIC COMPONENTS, ASSOCIATED PHOTONIC CIRCUIT AND MANUFACTURING METHOD

(30) Priorité: 29.10.2014 FR 1460386
(43) Date de publication de la demande: 04.05.2016
(73) Titulaire: Commissariat à l'Énergie Atomique et aux Énergies Alternatives, 75015 Paris (FR)
(72) Inventeur: HASSAN, Karim, 38500 Voiron (FR); SCIANCALEPORE, Corrado, 69002 Lyon (FR); DUPREZ, Hélène, 38170 Seyssinet-Parizet (FR); BEN-BAKIR, Badhise, 38590 Brezins (FR)
(74) Mandataire: Brevalex

(56) Documents cités:
- EP-A2- 2 759 858
- EP-B1- 1 282 834

## Description

### DOMAINE TECHNIQUE

Le domaine de l'invention est celui de la photonique et de l'optoélectronique sur silicium micro-nano-structuré. L'invention vise plus particulièrement un substrat localement pré-structuré pour la réalisation de composants photoniques intervenant notamment dans les réseaux de transmission de données par fibre optique et/ou en espace libre ou bien dans les circuits photoniques intégrés (intra-puce/inter-puce).

### ÉTAT DE LA TECHNIQUE ANTÉRIEURE

Les différents composants photoniques actifs et passifs forment une bibliothèque de composants complète qui permet de réaliser l'ensemble des fonctions nécessaire au traitement de l'information par la lumière sur puce, de l'émission à la réception, en passant par la transmission faible pertes, le multiplexage en longueur d'onde, et la manipulation haute fréquence de signaux. On retrouve dans cette bibliothèques les lasers, les composants RF (modulateurs, photodiodes), les composants passifs (guides, (de)multiplexeurs, filtres résonants, coupleurs), et les réseaux de (dé)couplage. Chacun de ces composants nécessite des préparations spécifiques pour atteindre leurs meilleures performances.

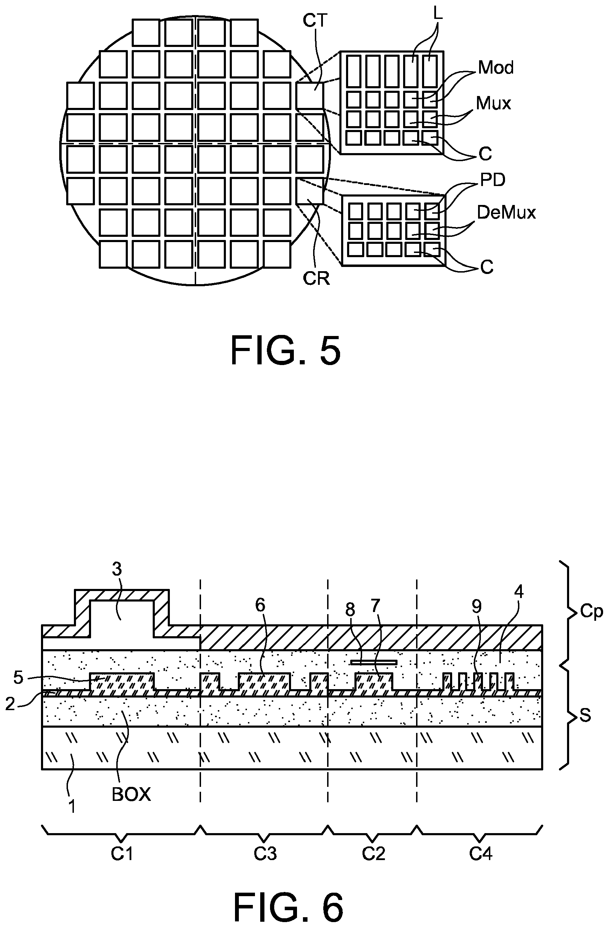

La figure 6 est une vue en coupe qui représente des composants photoniques actifs et passifs Cp réalisés sur un substrat silicium-sur-isolant SOI (*Silicon-On-Insulator*) comprenant une couche d'oxyde BOX intercalée entre une partie massive en silicium 1 et une couche mince superficielle de silicium 2. Quatre types de composants photoniques C1-C4 sont représentés sur la figure 6, avec de gauche à droite un laser C1, un modulateur C2, un composant passif de transmission C3 et un coupleur vers fibre optique C4.

Le laser C1 comprend un amplificateur optique 3 à semi-conducteur III-V reposant sur une couche d'oxyde 4 qui recouvre un guide d'ondes en arête 5 formé à partir de la couche mince 2 du substrat SOI.

Le modulateur C2 comprend une section de modulation de type diode pn ou pin 6 formée par structuration et dopage de la couche mince 2 du substrat SOI et recouverte de la couche d'oxyde 4.

Le composant passif C3 comprend un guide d'ondes en arête 7 formé à partirde la couche mince 2 du substrat SOI et recouvert de la couche d'oxyde 4. Une couche métallique 8 peut être intégrée dans la couche d'oxyde 4 en fin de processus de fabrication BEOL (*Back-End Of Line*) afin de servir d'élément chauffant.

Le coupleur vers fibre optique C4 comprend un réseau de couplage 9 formé par structuration de la couche mince 2 du substrat SOI et recouvert de la couche d'oxyde 4.

L'avènement de circuits photoniques intégrés soulève des problèmes de compatibilités entre ces différents composants photoniques C1-C4, en particulier entre composants passifs et composants actifs. En effet, certains paramètres intrinsèques provenant de la nature des matériaux utilisés et/ou de la fonctionnalité même des composants nécessitent une attention particulière lors de la conception.

L'indice de réfraction du silicium étant naturellement sensible aux variations de température, la plupart des composants passifs y sont également très sensibles, alors que certains composants du même circuit tirent profit de cette particularité pour effectuer des ajustements spatiaux-fréquentiels (parfois indispensables pour pallier les incertitudes de fabrication). D'autres composants actifs tels que les sources laser hybrides génèrent (et subissent) également des échauffements néfastes dont l'optimisation est indispensable pour des questions de fiabilité et de vieillissement.

L'intégration des différents composants sur un même substrat engendre donc des problèmes de compatibilité et d'efficacité. Il faudrait ainsi à la fois pouvoir contrôler de manière localisée la chaleur produite de manière indésirable par certains composants optoélectroniques comme les lasers, augmenter la résistivité du substrat pour les performances des composants optiques RF comme les modulateurs, diminuer/annuler la sensibilité thermique de composants optiques en silicium, récupérer la puissance optique perdue en direction du substrat pour des coupleurs de fibre, et enfin chauffer de manière rapide et efficace certains composants optiques.

Les solutions actuelles ne traitent ces problèmes qu'au cas par cas et ne permettent toujours pas d'envisager une intégration complète. On recherche donc une solution qui permette d'améliorer l'ensemble des performances de tout ou partie de la chaîne photonique (émission, modulation, transmission, etc.) en tirant le meilleur de chaque type de composant photonique de manière conjointe.

On connaît du brevet EP 1282 834 B1 des structures photoniques rendues athermiques par ajout de matériau polymère à même de compenser les variations d'indice de réfraction du silicium.

D'autres structures photoniques rendues athermiques sont par ailleurs connues de la demande EP 2759 858 A2 qui divulgue l'incorporation dans un guide d'ondes d'une couche en un matériau dont les propriétés thermiques s'opposent à celles du silicium de façon complémentaire.

### EXPOSÉ DE L'INVENTION

L'invention vise à fournir une solution en ce sens et propose pour ce faire un substrat localement pré-structuré pour la réalisation de composants photoniques, comportant :
- une partie massive en silicium ;
- une première région localisée du substrat, comprenant :
   ∘ une couche, dite de dissipation thermique, réalisée de manière localisée en surface de la partie massive et formée en un matériau dont l'indice de réfraction est inférieur à celui du silicium ;
   ∘ un guide d'ondes sur la couche de dissipation thermique ;
- une deuxième région localisée du substrat, distincte de la première région, comprenant :
   ∘ une couche d'oxyde réalisée de manière localisée en surface de la partie massive, l'oxyde présentant une conductivité thermique inférieure à celle du matériau de la couche de dissipation thermique ;
   ∘ un guide d'ondes sur la couche d'oxyde.

L'invention porte également sur un circuit photonique comprenant un amplificateur optique à semi-conducteur reposant sur une région localisée d'un substrat comprenant une partie massive en silicium, ladite région comprenant :
- une couche, dite de dissipation thermique, réalisée de manière localisée en surface de la partie massive en un matériau dont l'indice de réfraction est inférieur à celui du silicium ;
- un guide d'ondes sur la couche de dissipation thermique ;
- une couche recouvrant le guide d'ondes en un oxyde dont la conductivité thermique est inférieure à celle de la couche de dissipation thermique.

L'invention s'étend également au procédé de fabrication du substrat pré-structuré selon l'invention, et notamment à un procédé comprenant les étapes de :
- formation sur une première zone d'une partie massive en silicium, d'une couche, dite de dissipation thermique, en un matériau dont l'indice de réfraction est inférieur à celui du silicium ;
- formation sur une deuxième zone de la partie massive en silicium d'une couche en un oxyde dont la conductivité thermique est inférieure à celle du matériau de la couche de dissipation thermique ;
- report depuis un substrat donneur du matériau constitutif du guide d'ondes de la première région et du guide d'ondes de la deuxième région sur respectivement la couche de dissipation thermique et la couche d'oxyde de la seconde région.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est une vue en coupe d'un substrat selon un mode de réalisation possible de l'invention ;
- la figure 2 est une vue en coupe d'un circuit photonique élaboré sur un substrat conforme à l'invention ;
- les figures 3a-3g représentent une première variante d'un procédé de fabrication d'un substrat selon l'invention ;
- les figures 4a-4k représentent une deuxième variante d'un procédé de fabrication d'un substrat selon l'invention ;
- la figure 5 est une vue de dessus d'un substrat selon l'invention comprenant un ensemble de cellules photoniques élémentaires dans lesquelles on retrouve une pré-structuration pour un ensemble de composants photoniques ;
- la figure 6, déjà discutée précédemment, est une vue en coupe d'un circuit photonique de l'état de l'art élaboré sur un substrat SOI.

### EXPOSÉ DÉTAILLÉ DE MODES DE RÉALISATION PARTICULIERS

L'invention porte sur un substrat localement pré-structuré pour la réalisation de composants photoniques. Elle s'étend également à un composant photonique réalisé à partir d'un tel substrat, ainsi qu'à un procédé de fabrication d'un tel substrat.

L'invention permet d'anticiper les besoins spécifiques de chaque type de composant photonique en structurant localement à l'avance le substrat de manière adaptée pour garantir les meilleures performances de chaque type de composant. Les problématiques de compatibilité, d'efficacité, de gestion thermique et optique sont intégrées dans un même support physique, minimisant ainsi les étapes de post-fabrication, tout en garantissant de bonnes performances pour l'ensemble de la circuiterie photonique.

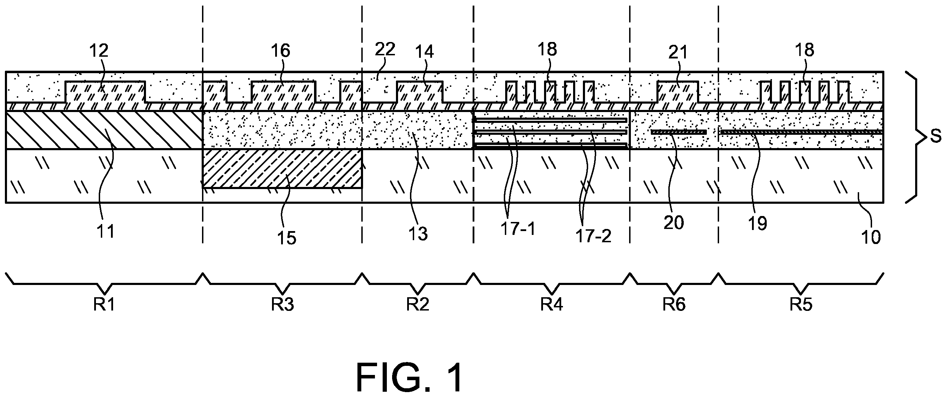

La figure 1 est une vue en coupe schématique d'un tel substrat pré-structuré dans un exemple de réalisation de l'invention illustrant l'ensemble des composants/fonctions photoniques pouvant être réalisés.

On relèvera notamment, par comparaison avec la figure 6, que la couche de silice d'un substrat SOI est substituée localement dans le cadre de l'invention, par des couches/structures d'intérêts pour les composants/fonctions photoniques actives et passives situés au-dessus. L'ensemble de ces composants/fonctions peuvent être implémentés au choix en fonction du type de circuit photonique à réaliser, de manière à minimiser les étapes de post-fabrication du substrat.

En référence à la figure 1, le substrat S selon l'invention comporte une partie massive en silicium 10, et une première région R1 localisée du substrat qui comprend une couche 11, dite de dissipation thermique, réalisée de manière localisée en surface de la partie massive 10 et formée en un matériau dont l'indice de réfraction est inférieur à celui du silicium, et un guide d'ondes 12 sur la couche de dissipation thermique 11.

Le substrat S comporte par ailleurs une deuxième région R2 localisée du substrat qui comprend une couche d'oxyde 13 réalisée de manière localisée en surface de la partie massive 10, l'oxyde présentant une conductivité thermique inférieure à celle du matériau de la couche de dissipation thermique 11. La deuxième région comprend en outre un guide d'ondes 14 sur la couche d'oxyde 13.

Les guides d'ondes 12, 14 peuvent être des guides d'ondes en arête comme représenté. Ils sont recouverts d'une couche d'oxyde 22, typiquement une couche de SiO₂.

Les guides d'ondes 12, 14 sont de préférence réalisés en silicium monocristallin. En particulier, comme cela sera détaillé par la suite, le matériau constitutif des guides d'ondes 12, 14 peut avoir été reporté depuis un même substrat donneur sur, respectivement, la couche de dissipation thermique 11 de la première région R1 et la couche d'oxyde 13 de la seconde région R2.

La couche de dissipation thermique 11 est par exemple réalisée en AIN, Al₂O₃, ZnS, CaP, SiN. Elle forme une zone circonscrite du substrat qui forme un canal directionnel de transport de chaleur, qui peut être entourée d'oxyde 13 de manière à être isolée thermiquement.

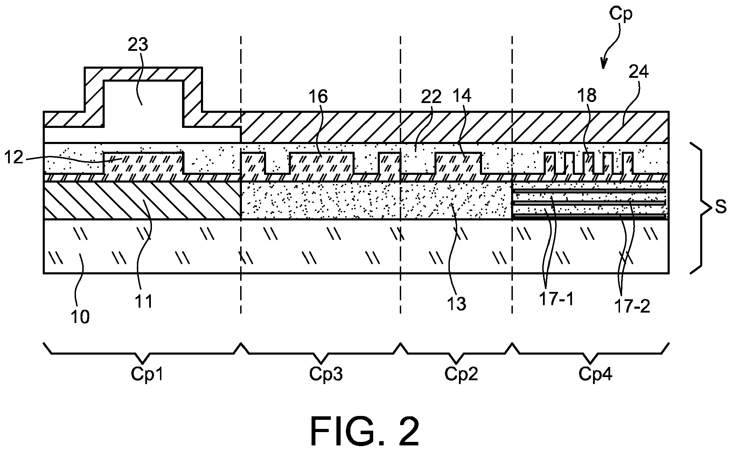

Comme représenté sur la figure 2 qui représente un circuit photonique Cp pouvant être réalisé dans le cadre de l'invention, la première région R1 du substrat pré-structuré peut être utilisée pour la constitution d'un premier composant photonique Cp1 de type laser. Le circuit photonique Cp comprend alors un amplificateur optique à semi-conducteur 23, notamment un amplificateur à matériau III-V, reposant sur la première région R1 du substrat S formée de la couche 11 de dissipation thermique, du guide d'ondes 12 et de la couche d'oxyde 22 recouvrant le guide d'ondes 12.

La couche de dissipation thermique 11 permet de mieux dissiper l'échauffement du laser qu'une couche d'oxyde, telle qu'une couche de silice d'un substrat SOI. Prenant l'exemple d'une couche de dissipation thermique 11 constituée d'alumine AIN, celle-ci permet de diminuer de 40% la température maximale au sein du laser par rapport à celle qu'attendrait le laser si la couche de dissipation thermique 11 était remplacée par une couche d'oxyde de silicium, en venant dissiper efficacement la chaleur en direction de la partie massive 10 du substrat. Une telle couche est par ailleurs sans impact sur les propriétés optiques du laser vu la faible différence sur l'indice effectif du mode optique guidé en comparaison avec la silice (<10⁻⁴).

Comme représenté sur la figure 2, la deuxième région R2 du substrat pré-structuré peut être utilisée pour la constitution d'un deuxième composant photonique Cp2 de type composant de guidage passif.

La couche d'oxyde 13 de la deuxième région R2 (figure 1) peut être une couche de SiO₂, le deuxième composant photonique Cp2 formant alors un composant de guidage passif standard, ou une couche de TiO₂ le deuxième composant photonique Cp2 formant alors un composant de guidage passif à faible sensibilité aux changements de température.

Le silicium possède une sensibilité intrinsèque aux changements de température qui modifie son indice de réfraction et donc les propriétés de propagation des ondes électromagnétiques qui y sont confinées. Ce problème récurrent de la photonique sur silicium est habituellement traité par un contrôle local ou global de la température, ce qui augmente drastiquement la consommation énergétique totale d'un circuit photonique. II est possible de réduire cette sensibilité thermo-optique, et éventuellement d'atteindre des conditions de fonctionnement athermique, grâce à certains matériaux dont les propriétés thermiques s'opposent à celles du silicium de façon complémentaire et compatible avec les fonctions de guidage optique. En particulier, le dioxyde de titane satisfait à la fois les propriétés thermo-optiques recherchées et les contraintes de fabrications industrielles dans le cadre d'une intégration compatible CMOS. Il peut donc être utilement utilisé comme matériau constitutif de la couche d'oxyde 13 de la deuxième région R2.

En revenant à la figure 1, le substrat pré-structuré peut comporter une une troisième région R3 localisée du substrat et formée sur une portion superficielle 15 localisée de la partie massive 10 dans laquelle des ions sont implantés. La troisième région R3 comprend une couche d'oxyde 13 sur ladite portion superficielle 15 et une section de modulation de type diode pn ou pin 16.

La couche d'oxyde de la troisième région est par exemple une couche de silice. La section de modulation 16 est formée de silicium monocristallin convenablement structuré et dopé pour réaliser une diode pn ou pin.

L'utilisation de substrats en silicium pour les interconnections électriques hautes fréquences nécessite une adaptation de l'impédance du substrat afin de réduire les problèmes de capacités parasites et de pertes néfastes pour les composants à radiofréquence (RF) (génération de bruit qui se propage dans le substrat et impacte la circuiterie RF avoisinante). Ce problème de diaphonie entre composants RF sur silicium peut être traité en venant augmenter la résistance d'un substrat silicium massif afin d'empêcher la propagation des signaux entre composants RF. L'invention propose ainsi d'inclure dans le substrat pré-structuré une région localisée où la partie massive en silicium est rendue hautement résistif grâce à une implantation d'ions (par exemple H+, ou As+), à savoir ladite portion superficielle 15.

Dans une variante de réalisation, la troisième région R3 comprend en outre une couche de passivation (non représentée) intercalée entre ladite portion superficielle 15 et la couche d'oxyde 13, par exemple une couche de passivation en poly-silicium, également dénommé silicium poly-cristallin. Cette couche de passivation vise à passiver l'interface entre la couche d'oxyde et le silicium haute résistivité où une forte conduction parasite de surface pourrait se créer.

On relèvera que la portion superficielle 15 de silicium haute résistivité est obtenue par dopage ou implantation d'ions et qu'elle est en conséquence sensible aux traitements thermiques subies lors des diverses étapes de fabrication. Un procédé de fabrication préservant des traitements thermiques trop important sera décrit par la suite qui permet de conserver la haute résistivité.

Comme représenté sur la figure 2, la troisième région R3 du substrat pré-structuré peut être utilisée pour la constitution d'un troisième composant photonique Cp3 de type modulateur. Toutefois la pré-structuration haute résistivité peut également profiter à d'autres composants RF (connections électriques dans le même plan par exemple), rendant ainsi le substrat selon l'invention encore plus versatile (permettant par exemple en outre l'intégration de circuits de commande).

En revenant à la figure 1, le substrat pré-structuré peut comporter une une quatrième région R4 localisée du substrat qui comprend un miroir multicouche réalisée de manière localisée sur la partie massive 10 et une section de couplage vers fibre optique 18 sur le miroir multicouche. Le miroir multicouche est formé d'une alternance de couches d'oxyde 17-1, typiquement des couches de SiO₂, et de couches de silicium 17-2. Il permet d'optimiser le couplage du circuit photonique vers une fibre optique en récupérant l'intensité perdue en direction du substrat.

Pour les applications moyennes et longues distances (i.e. de quelques mètres à plusieurs kilomètres), le moyen de transport privilégié est la fibre optique. Il est donc nécessaire de transférer la lumière du circuit photonique vers le réseau fibré existant par un coupleur optique. Celui-ci peut être un raccord progressif (*taper*) inversé ou un réseau de couplage qui transfère le faisceau laser de taille sub-micronique vers une fibre monomode ou multimode qui supporte un mode dont le diamètre est supérieur à 10µm. Ces coupleurs optiques assurent un transfert efficace (peu de pertes). Ce type de couplage est perfectionné dans le cadre de l'invention par l'ajout d'un réflecteur (le miroir multicouche) sous le réseau de (dé)couplage afin de récupérer efficacement la partie de signal optique perdue en direction du substrat. A titre d'exemple, un réseau de (dé)couplage sur un miroir composé de deux périodes de silice/silicium permet de réfléchir 84% du signal incident en direction de la fibre alors que le même réseau réalisé sur un substrat SOI ne réfléchit que 65% du signal incident.

Comme représenté sur la figure 2, la quatrième région R4 du substrat pré-structuré peut être utilisée pour la constitution d'un quatrième composant photonique Cp4 de type coupleur vers fibre optique.

Toujours en référence à la figure 1, le substrat pré-structuré peut comporter une cinquième région R5 localisée du substrat qui comprend une couche d'oxyde 13 sur la partie massive 1, ladite couche d'oxyde incorporant une couche métallique 19, et une section de couplage vers fibre optique 18 sur la couche d'oxyde 13. La couche métallique 19 joue ici le rôle de miroir pour assurer la même fonction de réflexion de la partie de signal optique perdue en direction du substrat.

Le substrat pré-structuré peut en outre comprendre une sixième région R6 localisée du substrat qui comprend une couche 13 sur la partie massive 10, ladite couche incorporant une couche métallique 20, et un guide d'ondes 21 sur ladite couche 13. La couche métallique 20 permet de chauffer efficacement et très rapidement des composants optiques. Elle peut être intégrée dans une couche d'oxyde, telle qu'une couche de silice, ou dans une couche en un matériau dont la conductivité thermique est supérieure à celle de l'oxyde et dont l'indice de réfraction est inférieur à celui du silicium, par exemple une couche réalisée en AlN, Al₂O₃, ZnS, CaP, ou SiN.

L'ajout de niveaux de métal pour la photonique s'effectue généralement uniquement lors des étapes de BEOL, donc après la réalisation des composants optoélectroniques. Déposer une couche métallique lors des étapes antérieures de fabrication est a priori impossible dans l'état actuel des outils de fabrication industriel (du fait de problèmes de contamination des équipements notamment). En venant structurer et encapsuler à l'avance un niveau métal dans un substrat dédié pour la photonique, l'invention apporte de multiples avantages.

Tout d'abord, la structuration multicouche proposée précédemment en tant que réflecteur de lumière intégré sous les sections de couplage peut être envisagée avec un seul niveau de métal encapsulé entre deux niveaux d'oxyde.

Ensuite, disposer de métal en dessous de certains composants permet de prédisposer *in situ* d'éléments chauffant tels que ceux aujourd'hui ajoutés pendant les étapes de BEOL, nécessaires aux bons ajustements spatiaux-fréquentiels. Ce type de fonctionnalisation du substrat permet également d'intégrer un niveau métal à l'intérieur d'un système multicouche à forte conductivité thermique (ce qui n'est pas le cas en BEOL où les niveaux de métal sont encapsulés dans de la silice, BCB, ou SiN parfois). Ainsi le matériau, par exemple l'AIN, proposé comme dissipateur de chaleur pour les lasers peut être avantageusement utilisé comme matériau conducteur de chaleur pour les ajustements spatiaux-fréquentiels de composants optiques, sans dégradation des performances (électro-)optiques. Une amélioration de la dynamique (temps de réponse) du chauffage/refroidissement est également obtenue avec une telle configuration.

La connexion électrique d'un tel niveau métallique en tant qu'élément chauffant peut être réalisée grâce à des vias standards, i.e. creusés au-dessus de la structure (type BEOL), ou bien grâce à des vias en face arrière appelés TSV (*Through Silicon Via*).

Si les différentes régions localisées du substrat pré-structuré portent le nom de première région, deuxième région, ..., sixième région, cet ordonnancement ne doit pas être entendu comme signifiant qu'une région d'ordre supérieur ne peut être présente que si l'ensemble des régions d'ordre inférieur sont également présentes. Au contraire, le substrat peut comprendre, au choix, l'une et/ou l'autre de ces régions R1-R6 prises seules ou selon une quelconque combinaison.

Un schéma standard réunissant l'ensemble des fonctionnalités précédemment décrites est néanmoins envisagé selon lequel un substrat complet est divisé en cellules photoniques élémentaires, où chaque cellule élémentaire regroupe des zones dédiées pour chaque fonctionnalité. La taille moyenne de chaque famille de composant est connue et les connexions sont assurées au sein d'une cellule par des guides silicium à faible pertes de propagation. Ce schéma standard est illustré par la figure 5, où l'on retrouve deux types de cellules photoniques élémentaires. Un premier type de cellules CT concerne les transmetteurs : on y retrouve des lasers L, des modulateurs Mod, des multiplexeurs Mux, des coupleurs C. Le deuxième type de cellules CR concerne les récepteurs : on y retrouve des coupleurs C, des démultiplexeurs DeMux, des photodiodes PD.

L'invention n'est pas limitée au substrat pré-structuré tel que précédemment décrit, mais s'étend à un circuit photonique réalisé à partir d'un tel substrat comme représenté sur la figure 2, et en particulier à un circuit photonique Cp1 comprenant un amplificateur optique à semi-conducteur 22 reposant sur une région R1 localisée d'un substrat comprenant une partie massive en silicium 10, ladite région R1 comprenant :
- une couche 11, dite de dissipation thermique, réalisée de manière localisée en surface de la partie massive 10 en un matériau dont l'indice de réfraction est inférieur à celui du silicium ;
- un guide d'ondes 12 sur la couche de dissipation thermique 11;
- une couche 22 recouvrant le guide d'ondes 12 en un oxyde dont la conductivité thermique est inférieure à celle de la couche de dissipation thermique 11.

Une couche d'encapsulation 24, par exemple en SiN, TiO2, AlN ou BCB, vient recouvrir le circuit photonique Cp.

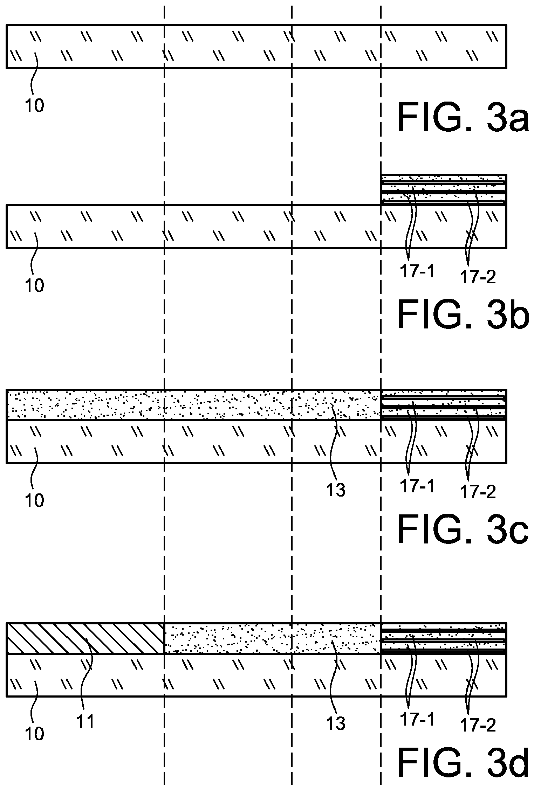

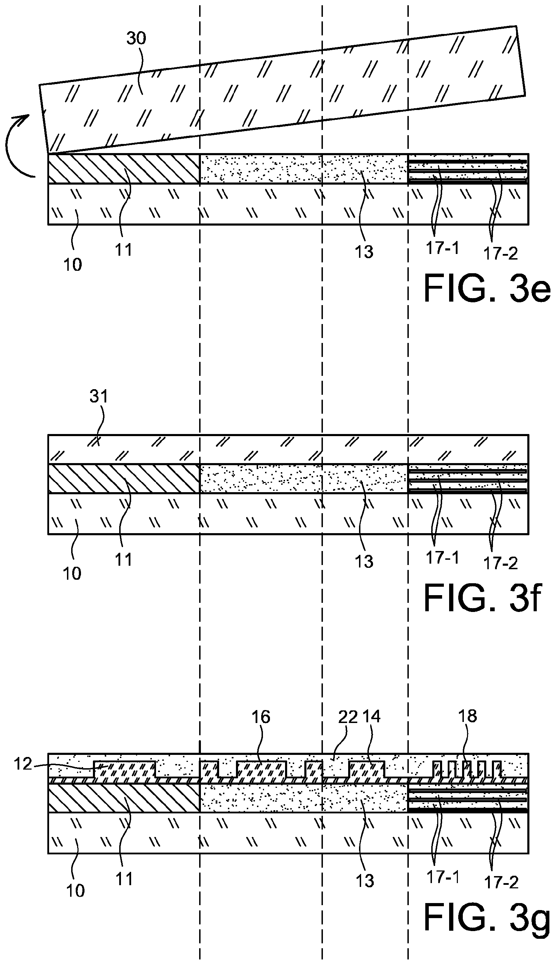

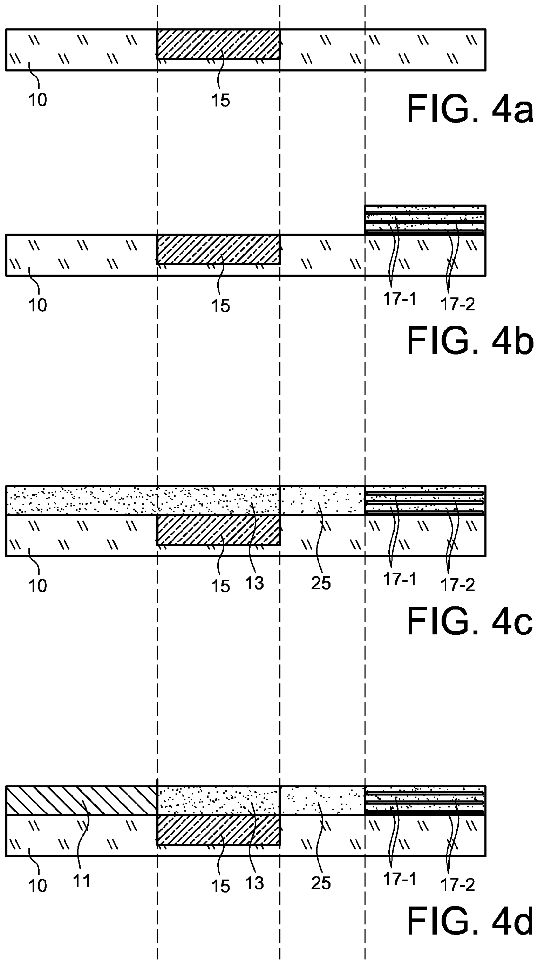

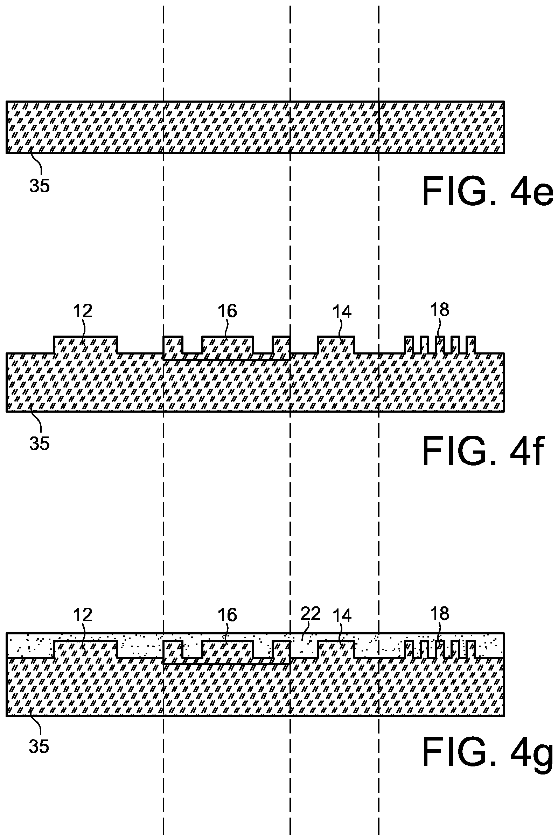

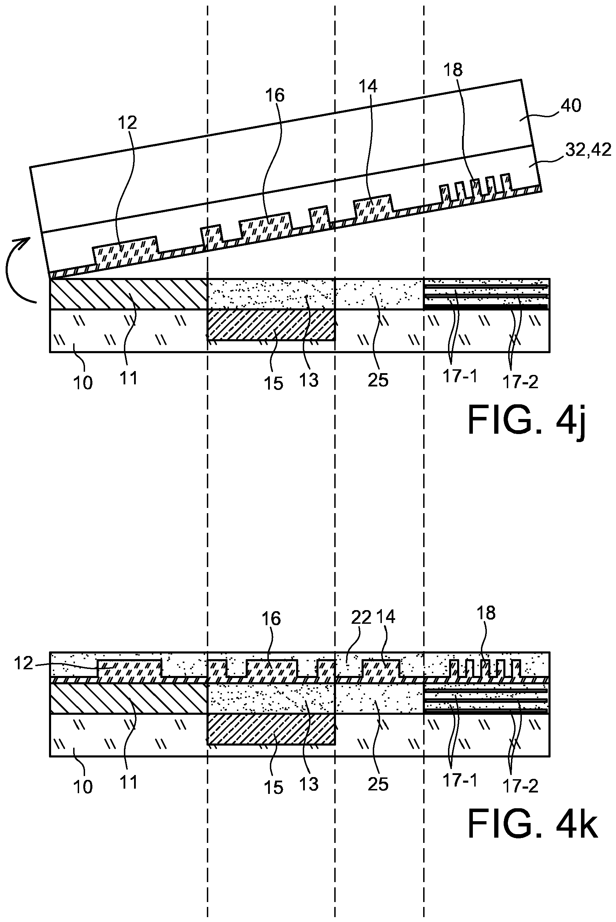

On décrit par la suite un procédé de fabrication du substrat pré-structuré selon l'invention. Cette description est faite en référence aux figures 3a-3g et 4a-4k qui illustrent deux variantes de réalisation possible de ce procédé.

Comme illustré sur les figures 3a et 4a, la fabrication du substrat pré-structuré selon l'invention utilise comme base de départ un substrat de silicium monocristallin 10, appelé partie massive de silicium dans ce document.

Comme illustré sur les figures 3c-3d et 4c-4d, la fabrication du substrat pré-structuré comprend ensuite une étape de formation sur une première zone de la partie massive en silicium 10, d'une couche 11, dite de dissipation thermique, en un matériau dont l'indice de réfraction est inférieur à celui du silicium, et une étape de formation sur une deuxième zone de la partie massive en silicium 10 d'une couche 13 en un oxyde dont la conductivité thermique est inférieure à celle du matériau de la couche de dissipation thermique 11.

Puis comme illustré sur les figures 3e-3g et 4j-4k, le procédé comprend le report depuis un substrat donneur 30, 40 du matériau constitutif du guide d'ondes de la première région et du guide d'ondes de la deuxième région sur respectivement la couche de dissipation thermique 11 et la couche d'oxyde 13 de la seconde région.

Dans le cadre de la variante illustrée par les figures 3a-3g, dite variante « simple report », cette étape de report consiste à transférer une couche de silicium monocristallin qui sera ensuite localement structurée, et éventuellement localement dopée, pourformer, selon les différentes régions pré-structurées souhaitées, les structures optoélectroniques en silicium monocristallin correspondantes (guides d'ondes, sections de modulations et sections de couplage notamment). Dans le cadre de la variante illustrée par les figures 4a-4k, dite variante « double report », cette étape de report consiste à transférer les structures optoélectroniques en silicium monocristallin souhaitées.

La variante « simple report » est la suivante. Partant d'une partie massive en silicium 10 (figure 3a), et lorsqu'une quatrième région R4 de couplage vers fibre optique est souhaitée, on précède à la formation du miroir multicouche sur une zone de la partie massive en venant alterner le dépôt de couches de silice 17-1 et de couches de silicium 17-2 (figure 3b). On procède ensuite (figure 3c) au dépôt d'une couche de silice 13 sur la partie massive en silicium 10. Une couche de TiO2 peut aussi être localement déposée lorsque l'on souhaite former une région pré-structurée pour composant athermique. Une couche de dissipation thermique peut aussi être localement déposée. Et une ou plusieurs couches métalliques peuvent être localement intégrées au sein de la couche de silice 13 ou de la couche de dissipation thermique pour servir de chaufferette ou de miroir.

Une gravure localisée de la couche de silice 13 est ensuite réalisée, suivie du dépôt localisé de la couche de dissipation thermique 11 de la première région R1, par exemple en AIN (figure 3d).

Puis, comme représenté aux figures 3e-3f, on vient ensuite procéder au report depuis un substrat donneur 30 d'une couche de silicium monocristallin 31 qui servira de matériau constitutif des structures optoélectroniques destinées à équiper les différentes régions souhaitées, en particulier le guide d'ondes 12 de la première région et le guide d'ondes 14 de la deuxième région pour lesquels ledit matériau constitutif est reporté sur respectivement la couche de dissipation thermique 11 et la couche d'oxyde 13 de la seconde région.

Le substrat donneur 30 peut être un substrat de silicium monocristallin ou un substrat SOI. Le report peut être réalisé selon le procédé Smart Cut^{™}, le substrat donneur 30 ayant été préalablement soumis à une implantation ionique pour y former une zone fragilisée au niveau de laquelle le substrat donneur pourra être séparé en deux parties, dont l'une correspond à la couche 31.

Puis en référence à la figure 3g, on vient réaliser les différentes structures optoélectroniques (guides d'ondes 12,14, sections de modulation 16, sections de couplage 14) par des étapes de lithographie, dopage, gravure, dépôt d'oxyde, polissage CMP, etc. appliquées à la couche reportée 31. Une couche de silice 22 vient recouvrir ces différentes structures.

Cette variante « simple report » présente l'avantage de la simplicité. Néanmoins, du fait des traitements thermiques mis en oeuvre notamment lors de la réalisation des différentes structures optoélectroniques, elle ne peut permettre de réaliser des composants RF exploitant du silicium haute résistivité.

La variante « double report » illustrée par les figures 4a-4k permet de contourner cette difficulté.

Partant d'une partie massive en silicium 10, une région superficielle localisée est soumise à une implantation afin de venir former une portion superficielle de haute résistivité 15 (figure 4a). Une couche de passivation peut venir recouvrir cette portion superficielle.

Lorsqu'une quatrième région R4 de couplage vers fibre optique est souhaitée, on procède à la formation du miroir multicouche sur une zone de la partie massive en venant alterner le dépôt de couches de silice 17-1 et de couches de silicium 17-2 (figure 4b). On précède ensuite (figure 4c) au dépôt d'une couche de silice 13 sur la partie massive en silicium 10. Dans l'exemple représenté, une couche de TiO2 25 est localement déposée pour former une région pré-structurée pour composant athermique. Une couche de dissipation thermique peut aussi être localement déposée. Et une ou plusieurs couches métalliques peuvent être localement intégrées au sein de la couche de silice 13 ou de la couche de dissipation thermique pour servir de chaufferette ou de miroir.

Une gravure localisée de la couche de silice 13 est ensuite réalisée, suivie du dépôt localisé de la couche de dissipation thermique 11 de la première région R1, par exemple en AIN (figure 4d)

Puis, comme représenté aux figures 4e-4f, on vient ensuite procéder à la formation des différentes structures opto-électroniques (guides d'ondes 12, 14, sections de modulation 16, sections de couplage 14) par des étapes de lithographie, dopage, gravure, dépôt d'oxyde, polissage CMP, etc. mises en oeuvre sur un substrat en silicium monocristallin 35, dit substrat intermédiaire. Une couche de silice 32 est déposée qui vient recouvrir ces différentes structures.

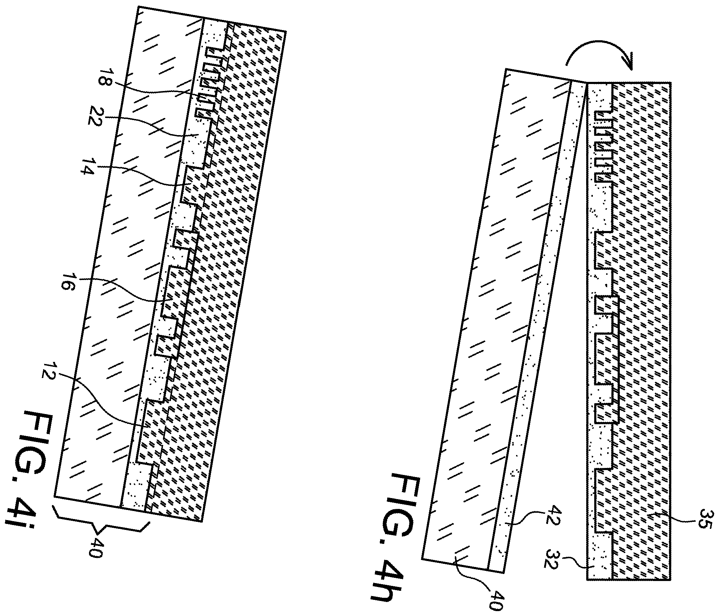

Puis comme représenté aux figures 4h et 4i, on vient procéder à un (premier) report des structures optoélectroniques 12, 14, 16, 18 depuis le substrat intermédiaire 35 vers un substrat, recouvert d'une couche de silice 42 dans l'exemple représenté, dit substrat donneur 40. Ce report peut être réalisé selon le procédé Smart Cut^{™}, le substrat intermédiaire 35 ayant été préalablement soumis à une implantation ionique pour y former une zone fragilisée au niveau de laquelle le substrat intermédiaire pourra être séparé en deux parties, dont l'une correspond à la couche de silice 32 et aux structures optoélectroniques 12, 14, 16, 18. A l'issue de ce report, les structures optoélectroniques 12,14,16,18 sont renversées sur le substrat donneur 40.

Un deuxième report est réalisé qui permet de remettre ces structures à l'endroit et d'obtenir un substrat pré-structuré conforme à l'invention. Ce deuxième report consiste à reporter les structures optoélectroniques depuis le substrat donneur 40 vers la partie massive en silicium 10 pré-structurée obtenue à l'issue de l'étape illustrée par la figure 4d. Ce report peut être réalisé selon le procédé Smart Cut^{™}, le substrat donneur 40 ayant été préalablement soumis à une implantation ionique pour y former une zone fragilisée, par exemple dans la couche de silice 32, 42, ou dans le substrat donneur 40 auquel cas on procède à une étape de retrait par gravure ou CMP du silicium résiduel.

Le circuit photonique Cp de la figure 2 peut ensuite être réalisé en venant finaliser l'intégration laser (collage de l'amplificateur optique 23 sur la première région), réaliser les vias et contacts et déposer la couche d'encapsulation 24.

## Revendications

1. Substrat (S) localement pré-structuré pour la réalisation de composants photoniques (Cp1-Cp4), comportant :
- une partie massive en silicium (10) ;
- une première région (R1) localisée du substrat, comprenant :
∘ une couche (11), dite de dissipation thermique, réalisée de manière localisée en surface de la partie massive (10) et formée en un matériau dont l'indice de réfraction est inférieur à celui du silicium ;
∘ un guide d'ondes (12) sur la couche de dissipation thermique (11) ;
- une deuxième région (R2) localisée du substrat, distincte de la première région (R1), comprenant :
∘ une couche d'oxyde (13) réalisée de manière localisée en surface de la partie massive (10), l'oxyde présentant une conductivité thermique inférieure à celle du matériau de la couche de dissipation thermique (11) ;
∘ un guide d'ondes (14) sur la couche d'oxyde.

2. Substrat selon la revendication 1, dans lequel le guide d'ondes (12) de la première région (R1) est formé de silicium monocristallin reporté d'un substrat donneur (30,40) sur la couche de dissipation thermique (11) et le guide d'ondes (14) de la deuxième région (R2) est formé de silicium monocristallin également reporté du substrat donneur (30, 40) sur la couche d'oxyde de la deuxième région (R2).

3. Substrat selon la revendication 1, dans lequel la couche de dissipation thermique (11) de la première région (R1) forme une zone circonscrite du substrat qui est entourée d'oxyde (13).

4. Substrat selon la revendication 1, dans lequel la couche d'oxyde (13) de la deuxième région (R2) est une couche de SiO₂ ou de TiO₂

5. Substrat selon l'une des revendications 1 à 4, comportant en outre une troisième région (R3) localisée du substrat et formée sur une portion superficielle localisée (15) de la partie massive (1) dans laquelle des ions sont implantés pour en augmenter la résistivité, la troisième région comprenant une couche d'oxyde (13) sur ladite portion superficielle (15) et une section de modulation de type diode pn ou pin (16) formée de silicium monocristallin dopé sur la couche d'oxyde (13).

6. Substrat selon la revendication 5, dans lequel la troisième région (R3) comprend en outre une couche de passivation intercalée entre ladite portion superficielle (15) et la première couche d'oxyde (16).

7. Substrat selon l'une des revendications 1 à 6, comportant en outre une quatrième région (R4) localisée du substrat qui comprend un miroir multicouche (17-1, 17-2) réalisé de manière localisée sur la partie massive et formé d'une alternance de couches d'oxyde (17-1) et de silicium (17-2), et une section de couplage vers fibre optique (18) sur le miroir multicouche.

8. Substrat selon l'une des revendications 1 à 7, comportant en outre une cinquième région (R5) localisée du substrat qui comprend une couche d'oxyde (13) sur la partie massive (10), ladite couche d'oxyde incorporant une couche métallique (19), et une section de couplage vers fibre optique (18) sur la couche d'oxyde (13).

9. Substrat selon l'une des revendications 1 à 8, comportant une sixième région (R6) localisée du substrat qui comprend une couche (13) sur la partie massive (10), ladite couche incorporant une couche métallique (20), et un guide d'ondes (14) sur ladite couche (13).

10. Substrat selon la revendication 9, dans lequel la couche (13) de la sixième région (R6) est une couche d'oxyde (13) ou une couche dont la conductivité thermique est supérieure à celle de l'oxyde et dont l'indice de réfraction est inférieur à celui du silicium.

11. Substrat selon l'une des revendications 1 à 10, dans lequel la couche de dissipation thermique est une couche de nitrure d'aluminium.

12. Circuit photonique (Cp1) comprenant un amplificateur optique à semi-conducteur (23) reposant sur une région (R1) localisée d'un substrat comprenant une partie massive en silicium (10), ladite région (R1) comprenant :
- une couche (11), dite de dissipation thermique, réalisée de manière localisée en surface de la partie massive (10) en un matériau dont l'indice de réfraction est inférieur à celui du silicium ;
- un guide d'ondes (12) sur la couche de dissipation thermique (11);
- une couche (22) recouvrant le guide d'ondes (12) en un oxyde dont la conductivité thermique est inférieure à celle de la couche de dissipation thermique (11).

13. Procédé de fabrication d'un substrat (S) selon la revendication 1, comprenant les étapes de :
- formation sur une première zone d'une partie massive en silicium (10), d'une couche (11), dite de dissipation thermique, en un matériau dont l'indice de réfraction est inférieur à celui du silicium ;
- formation sur une deuxième zone de la partie massive en silicium (10) d'une couche (13) en un oxyde dont la conductivité thermique est inférieure à celle du matériau de la couche de dissipation thermique (11) ;
- report depuis un substrat donneur (30, 40) du matériau constitutif du guide d'ondes de la première région et du guide d'ondes de la deuxième région sur respectivement la couche de dissipation thermique (11) et la couche d'oxyde (13) de la seconde région.

14. Procédé selon la revendication 13, dans lequel l'étape de report consiste à transférer une couche de silicium monocristallin (31) depuis le substrat donneur (30) et comprenant en outre une étape de formation du guide d'ondes de la première région et du guide d'ondes de la deuxième région à partir de la couche de silicium monocristallin transférée.

15. Procédé selon la revendication 13, comprenant en outre, avant l'étape de report depuis le substrat donneur, une étape de formation du guide d'ondes de la première région et du guide d'ondes de la deuxième région dans un substrat intermédiaire (35) et une étape de report du guide d'ondes de la première région et du guide d'ondes de la deuxième région du substrat intermédiaire (35) vers le substrat donneur (40).

## Patentansprüche

1. Lokal vorstrukturiertes Substrat (S) für die Herstellung von photonischen Komponenten (Cp1-Cp4), umfassend:
- einen massiven Teil aus Silicium (10);
- eine erste lokalisierte Region (R1) des Substrats, umfassend:
∘ eine sogenannte thermische Dissipationsschicht (11), die in lokalisierter Weise an der Oberfläche des massiven Teils (10) realisiert und aus einem Material gebildet ist, dessen Brechungsindex kleiner als jener von Silicium ist;
∘ einen Wellenleiter (12) auf der thermischen Dissipationsschicht (11);
- eine zweite lokalisierte Region (R2) des Substrats, die von der ersten Region (R1) verschieden ist, umfassend:
∘ eine Oxidschicht (13), die in lokalisierter Weise an der Oberfläche des massiven Teils (10) realisiert ist, wobei das Oxid eine thermische Leitfähigkeit aufweist, die kleiner ist als jene des Materials der thermischen Dissipationsschicht (11);
∘ einen Wellenleiter (14) auf der Oxidschicht.

2. Substrat nach Anspruch 1, bei dem der Wellenleiter (12) der ersten Region (R1) aus monokristallinem Silicium gebildet ist, das von einem Gebersubstrat (30, 40) auf die thermische Dissipationsschicht (11) übertragen ist, und der Wellenleiter (14) der zweiten Region (R2) aus monokristallinem Silicium gebildet ist, das ebenfalls von dem Gebersubstrat (30, 40) auf die Oxidschicht der zweiten Region (R2) übertragen ist.

3. Substrat nach Anspruch 1, bei dem die thermische Dissipationsschicht (11) der ersten Region (R1) eine umgrenzte Zone des Substrats bildet, die von Oxid (13) umgeben ist.

4. Substrat nach Anspruch 1, bei dem die Oxidschicht (13) der zweiten Region (R2) eine Schicht aus SiO₂ oder TiO₂ ist.

5. Substrat nach einem der Ansprüche 1 bis 4, ferner umfassend eine dritte lokalisierte Region (R3) des Substrats, die auf einem lokalisierten Oberflächenbereich (15) des massiven Teils (1) gebildet ist, in der Ionen implantiert sind, um ihren Widerstand zu erhöhen, wobei die dritte Region eine Oxidschicht (13) auf dem Oberflächenbereich (15) und einen Modulationsabschnitt vom Typ pn- oder pin-Diode (16) umfasst, der aus dotiertem monokristallinem Silicium auf der Oxidschicht (13) gebildet ist.

6. Substrat nach Anspruch 5, bei dem die dritte Region (R3) ferner eine Passivierungsschicht umfasst, die zwischen dem Oberflächenbereich (15) und der ersten Oxidschicht (16) eingefügt ist.

7. Substrat nach einem der Ansprüche 1 bis 6, ferner umfassend eine vierte lokalisierte Region (R4) des Substrats, die einen Multilayerspiegel (17-1, 17-2) umfasst, der in lokalisierter Weise auf dem massiven Teil realisiert und aus einer alternierenden Folge von Oxidschichten (17-1) und Siliciumschichten (17-2) gebildet ist, sowie einen Abschnitt zur Kopplung an eine optische Faser (18) auf dem Multilayerspiegel.

8. Substrat nach einem der Ansprüche 1 bis 7, ferner umfassend eine fünfte lokalisierte Region (R5) des Substrats, die eine Oxidschicht (13) auf dem massiven Teil (10) umfasst, wobei die Oxidschicht eine Metallschicht (19) enthält, und einen Abschnitt zur Kopplung an eine optische Faser (18) auf der Oxidschicht (13).

9. Substrat nach einem der Ansprüche 1 bis 8, umfassend eine lokalisierte sechste Region (R6) des Substrats, die eine Schicht (13) auf dem massiven Teil (10) umfasst, wobei die Schicht eine Metallschicht (20) enthält, und einen Wellenleiter (14) auf der Schicht (13).

10. Substrat nach Anspruch 9, bei dem die Schicht (13) der sechsten Region (R6) eine Oxidschicht (13) ist oder eine Schicht, deren thermische Leitfähigkeit größer ist als jene des Oxids, und deren Brechungsindex kleiner ist als jener von Silicium.

11. Substrat nach einem der Ansprüche 1 bis 10, bei dem die thermische Dissipationsschicht eine Aluminiumnitridschicht ist.

12. Photonischer Schaltkreis (Cp1), umfassend einen optischen Halbleiterverstärker (23), der auf einer lokalisierten Region (R1) eines Substrats ruht, das einen massiven Teil aus Silicium (10) umfasst, wobei die Region (R1) umfasst:
- eine sogenannte thermische Dissipationsschicht (11), die in lokalisierter Weise an der Oberfläche des massiven Teils (10) aus einem Material realisiert ist, dessen Brechungsindex kleiner ist als jener von Silicium;
- einen Wellenleiter (12) auf der thermischen Dissipationsschicht (11);
- eine den Wellenleiter (12) bedeckende Schicht (22) aus einem Oxid, dessen thermische Leitfähigkeit kleiner ist als jene der thermischen Dissipationsschicht (11).

13. Verfahren zur Herstellung eines Substrats (S) nach Anspruch 1, umfassend die folgenden Schritte:
- Bilden einer sogenannten thermischen Dissipationsschicht (11) aus einem Material, dessen Brechungsindex kleiner ist als jener von Silicium, auf einer ersten Zone eines massiven Teils aus Silicium (10);
- Bilden einer Schicht (13) aus einem Oxid, dessen thermische Leitfähigkeit kleiner ist als jene des Materials der thermischen Dissipationsschicht (11), auf einer zweiten Zone des massiven Teils aus Silicium (10);
- Übertragen des Materials, aus dem der Wellenleiter der ersten Region und der Wellenleiter der zweiten Region gebildet ist, von einem Gebersubstrat (30, 40) auf die thermische Dissipationsschicht (11) beziehungsweise die Oxidschicht (13) der zweiten Region.

14. Verfahren nach Anspruch 13, bei dem der Übertragungsschritt darin besteht, eine Schicht aus monokristallinem Silicium (31) von dem Gebersubstrat (30) zu transferieren, und das ferner einen Schritt des Bildens des Wellenleiters der ersten Region und des Wellenleiters der zweiten Region ausgehend von der transferierten Schicht aus monokristallinem Silicium umfasst.

15. Verfahren nach Anspruch 13, ferner umfassend, vor dem Schritt des Übertragens von dem Gebersubstrat, einen Schritt des Bildens des Wellenleiters der ersten Region und des Wellenleiters der zweiten Region in einem Zwischensubstrat (35), und einen Schritt des Übertragens des Wellenleiters der ersten Region und des Wellenleiters der zweiten Region von dem Zwischensubstrat (35) zu dem Gebersubstrat (40).

## Claims

1. Substrate (S) locally pre-structured for the production of photonic components (Cp1-Cp4), comprising:
- a solid part made of silicon (10);
- a first localised region (R1) of the substrate, comprising:
∘ a layer (11), called heat dissipation layer, produced in a localised manner on the surface of the solid part (10) and made of a material of which the refractive index is less than that of silicon;
∘ a wave guide (12) on the heat dissipation layer (11);
- a second localised region (R2) of the substrate, separate from the first region (R1), comprising:
∘ an oxide layer (13) produced in a localised manner on the surface of the solid part (10), the oxide having a heat conductivity less than that of the material of the heat dissipation layer (11);
∘ a wave guide (14) on the oxide layer.

2. Substrate according to claim 1, in which the wave guide (12) of the first region (R1) is made of monocrystalline silicon transferred from a donor substrate (30, 40) onto the heat dissipation layer (11) and the wave guide (14) of the second region (R2) is made of monocrystalline silicon also transferred from the donor substrate (30, 40) onto the oxide layer of the second region (R2).

3. Substrate according to claim 1, in which the heat dissipation layer (11) of the first region (R1) forms a confined area of the substrate which is surrounded by oxide (13).

4. Substrate according to claim 1, in which the oxide layer (13) of the second region (R2) is a layer of SiO₂ or TiO₂.

5. Substrate according to one of claims 1 to 4, further comprising a third localised region (R3) of the substrate and formed on a localised superficial portion (15) of the solid part (1) in which ions are implanted to increase the resistivity thereof, the third region comprising an oxide layer (13) on said superficial portion (15) and a modulation section of pn or pin diode type (16) made of monocrystalline silicon doped on the oxide layer (13).

6. Substrate according to claim 5, in which the third region (R3) further includes a passivation layer intersected between said superficial portion (15) and the first oxide layer (16).

7. Substrate according to one of claims 1 to 6, further comprising a fourth localised region (R4) of the substrate which includes a multilayer mirror (17-1, 17-2) produced in a localised manner on the solid part and made of an alternation of layers of oxide (17-1) and of silicon (17-2), and an optical fibre coupling section (18) on the multilayer mirror.

8. Substrate according to one of claims 1 to 7, further comprising a fifth localised region (R5) of the substrate which includes an oxide layer (13) on the solid part (10), said oxide layer incorporating a metal layer (19), and an optical fibre coupling section (18) on the oxide layer (13).

9. Substrate according to one of claims 1 to 8, comprising a sixth localised region (R6) of the substrate which includes a layer (13) on the solid part (10), said layer incorporating a metal layer (20), and a wave guide (14) on said layer (13).

10. Substrate according to claim 9, in which the layer (13) of the sixth region (R6) is an oxide layer (13) or a layer of which the heat conductivity is greater than that of the oxide and of which the refractive index is less than that of silicon.

11. Substrate according to one of claims 1 to 10, in which the heat dissipation layer is a layer of aluminium nitride.

12. Photonic circuit (Cp1) comprising a semi-conductor optical amplifier (23) lying on a localised region (R1) of a substrate comprising a solid part made of silicon (10), said region (R1) comprising:
- a layer (11), called heat dissipation layer, produced in a localised manner on the surface of the solid part (10) made of a material of which the refractive index is less than that of silicon;
- a wave guide (12) on the heat dissipation layer (11);
- a layer (22) covering the wave guide (12) made of an oxide of which the heat conductivity is less than that of the heat dissipation layer (11).

13. Method of manufacturing a substrate (S) according to claim 1, comprising the steps of:
- formation on a first zone of a solid part made of silicon (10) of a layer (11), called heat dissipation layer, made of a material of which the refractive index is less than that of silicon;
- formation on a second zone of the solid part made of silicon (10) of a layer (13) made of an oxide of which the heat conductivity is less than that of the material of the heat dissipation layer (11);
- transfer from a donor substrate (30, 40) of the material constituting the wave guide of the first region and the wave guide of the second region onto respectively the heat dissipation layer (11) and the oxide layer (13) of the second region.

14. Method according to claim 13, in which the transfer step consists in transferring a monocrystalline silicon layer (31) from the donor substrate (30) and further comprising a step of formation of the wave guide of the first region and the wave guide of the second region from the transferred monocrystalline silicon layer.

15. Method according to claim 13, further comprising, before the step of transfer from the donor substrate, a step of formation of the wave guide of the first region and the wave guide of the second region in an intermediate substrate (35) and a step of transferring the wave guide of the first region and the wave guide of the second region of the intermediate substrate (35) to the donor substrate (40).
